# EUROPÄISCHE PATENTSCHRIFT

(11) **EP 0 222 787 B1**
(45) Veröffentlichungstag und Bekanntmachung des Hinweises auf die Patenterteilung: **19.05.1993**
(21) Anmeldenummer: 86902316.8
(22) Anmeldetag: 03.04.1986
(51) Int. Cl.: G03B 41/00, G03F 9/00

(54) **VERFAHREN UND ANORDNUNG ZUR AUSRICHTUNG, PRÜFUNG UND/ODER VERMESSUNG ZWEIDIMENSIONALER OBJEKTE**
METHOD AND DEVICE FOR ALIGNING, CONTROLLING AND/OR MEASURING BIDIMENSIONAL OBJECTS
PROCEDE ET DISPOSITIF POUR ALIGNER, CONTROLER ET/OU MESURER DES OBJETS BIDIMENSIONNELS

(30) Priorität: 11.05.1985 DE 3517070
(43) Veröffentlichungstag der Anmeldung: 27.05.1987
(73) Patentinhaber: Leica Industrieverwaltung GmbH, D-35530 Wetzlar (DE)
(72) Erfinder: SCHUSTER, Erich, D-6338 Hüttenberg (DE)
(86) Internationale Anmeldenummer: DE8600146
(87) Internationale Veröffentlichungsnummer: WO8606852

(56) Entgegenhaltungen:
- EP-A- 0 218 613
- DE-A- 3 305 014
- US-A- 3 865 483
- US-A- 4 165 149
- US-A- 4 251 160

## Beschreibung

Die Erfindung betrifft ein Verfahren und eine Anordnung zur Ausrichtung, Prüfung und/oder Vermessung zweidimensionaler, auf einem wenigstens in zwei senkrecht zueinander verlaufenden Koordinatenrichtungen verschiebbaren Tisch einer Meßmaschine befindlicher Objekte.

Mit Verfahren und Anordnungen dieser Art werden beispielsweise Strukturen von Masken oder Wafern erfaßt, ausgerichtet, geprüft und/oder vermessen.

Aus der europäischen Anmeldung Nr. 86 901 820, nunmehr EP-A-0 218 613, die unter Artikel 54(3) EPÜ fällt, ist dazu eine Anordnung bekannt, bei welcher zur Ermittlung der koordinatenmäßigen Lage der Objekte durch Abtastung mittels eines Lichtflecks die aus einer Beleuchtungseinrichtung je Koordinatenrichtung erzeugten Lichtflüsse in einem Strahlengang vereinigt und durch ein strahlensammelndes System in einer gemeinsamen Zwischenbildebene abgebildet werden. Sie werden außerdem durch ein optisches Glied entsprechend den ihnen zugeordneten Koordinatenrichtungen ausgelenkt und von einem abbildenden System auf die jeweils zu vermessenden Objekte projiziert. Die von dem jeweiligen Objekt reflektierten Lichtflüsse werden von wenigstens einem fotoelektrischen Empfängersystem in elektrische Meßsignale umgesetzt, aus denen in einem Rechner in Abhängigkeit von der Ablenkung des Lichtfleckes und der Stellung des Meßmaschinentisches die den Objekten entsprechenden Größen ermittelt werden.

Nachteil der beschriebenen Einrichtung ist, daß die Messung in den einzelnen Koordinatenrichtungen nur nacheinander erfolgen kann und daß, infolge der bei der Abbildung der sehr schmalen Lichtflecke auftretenden Lichtbeugung die Lage der Objektkanten nur mit begrenzter Genauigkeit erfaßt werden kann.

In der Patentschrift US-A-3 865 483 wird ein Beleuchtungssystem für ein zweikanaliges elektrooptisches Alignment-System beschrieben, in dem die Lichtströme durch ihre Polarisation unterscheiden und daraufhin dem jeweiligen Kanal zugeordnet werden.

In der US-A-4 165 149 wird ein optisches Scanninggerät nach dem Prinzip der Dunkelfeldmethode beschreiben, bei dem nur Licht das von geneigten Probenflächen reflektiert wird, detektiert wird. Die den x- und y-Koordinaten zugeordneten Strahlen werden, ohne sie kennzeichnen zu müssen, auf getrennten optischen Wegen geführt. Die beiden Koordina-tenrichtungen können nicht zeitgleich gescannt werden. Eine Anwendung als Meßsystem ist nicht vorgesehen oder realisiert.

Um die Nachteile des Standes der Technik zu beheben, liegt der Erfindung daher die Aufgabe zugrunde, ein Verfahren und eine Anordnung anzugeben, bei welchen eine zeitgleiche Messung in beiden Koordinatenrichtungen erfolgen kann, die Abtastgenauigkeit durch die Abbildung sehr kleiner Lichtflecke nicht negativ beeinflußt wird und außerdem eine geringe Temperaturbelastung des Objektes sichergestellt ist.

Gegenstand der Erfindung ist ein Verfahren der eingangs genannten Art, bei welchem nach zugeordneten Koordinatenrichtungen unterscheidbare, in einem Strahlengang vereinigte Lichtflüsse in einer gemeinsamen Zwischenbildebene abgebildet und durch ein optisches Glied entsprechend ihren Koordinatenrichtungen ausgelenkt, von einem abbildenden System auf das jeweils zu vermessende Objekt projiziert werden und welches aus den Schritten
a) Erzeugen eines Leuchtstreifens mit für jede Koordinatenrichtung unterscheidbaren, in einem gemeinsamen Strahlengang vereinigten Lichtflüssen, sowie Umlenken dieses Strahlenganges an einem in seiner Lage veränderbaren optischen Bauteil,
b) Erzeugen eines getrennten Leuchtstreifens je Koordinatenrichtung aus den unterscheidbaren Lichtflüssen und Abbilden dieser Leuchtstreifen in einer Zwischenbildebene,
c) Projizieren der Leuchtstreifen auf die Objektstrukturen des jeweils zu vermessenden Objekts,
d) Abbilden der durch die Leuchtstreifen beleuchteten Objektstrukturen in einer weiteren Zwischenbildebene,
e) Zusammenführen der den Bildern der Objektstrukturen zugeordneten Lichtflüsse in einem gemeinsamen Strahlengang und Umlenkung dieses Strahlenganges an dem in seiner Lage veränderbaren optischen Bauteil,
f) synchrones Verlagern sowohl der Bilder der Leuchtstreifen als auch der Bilder der Objektstrukturen in beiden Koordinatenrichtungen durch Veränderung der Lage des optischen Bauteils, wobei dessen momentane Lage durch ein zugeordnetes Gebersystem erfaßt wird,
g) Abbilden der Bilder der Objektstrukturen getrennt nach den den Koordinatenrichtungen zugeordneten Lichtflüssen auf Abtastmittel,
h) Umsetzen der jeweiligen aus der Abtastung der Objektstrukturbilder resultierenden Lichtflüsse in elektrische Meßsignale und
i) Auswertung dieser Meßsignale in Verbindung mit den Signalen des Gebersystems zum Zwecke der Meßwerterfassung, Anzeige, Steuerung und/oder Regelung
besteht.

Die erfindungsgemäße Anordnung zur Durchführung des Verfahrens enthält
a) eine strahlenbegrenzende Mittel enthaltende Beleuchtungseinrichtung zum Erzeugen eines Leuchtstreifens, in dem für jede Koordinatenrichtung unterscheidbare Lichtflüsse vereinigt sind,
b) eine erste Tubusoptik zur Abbildung des Leuchtstreifens in eine Zwischenbildebene,
c) in den Abbildungsstrahlengang vor der Zwischenbildebene eingefügte strahlenteilende und bilddrehende optische Mittel zum Erzeugen eines entsprechend den unterscheidbaren Lichtflüssen getrennten Leuchtstreifens je Koordinatenrichtung,
d) ein der Zwischenbildebene nachgeordnetes, ein Teilerprisma und ein abbildendes System enthaltendes optisches System zur Projektion der Leuchtstreifen auf die Objektstrukturen des jeweils zu vermessenden Objekts und zur Abbildung der von den Objektstrukturen reflektierten Lichtflüsse in eine weitere Zwischenbildebene,
e) ein zweites strahlenteilendes und bilddrehendes optisches Glied zur Zusammenführung der den Bildern der Objektstrukturen zugeordneten Lichtflüsse in einem gemeinsamen Strahlengang,
f) eine dem optischen Glied nachgeordnete zweite Tubusoptik mit einem Teilerprisma zur Abbildung der Bilder der Objektstrukturen auf Abtastmittel getrennt nach den den Koordinatenrichtungen zugeordneten Lichtflüssen,
g) ein der ersten Tubusoptik nachgeordnetes und der zweiten Tubusoptik vorgeschaltetes, in seiner Lage veränderbares optisches Bauteil zur synchronen Verlagerung sowohl der Bilder der Leuchtstreifen als auch der Bilder der Objektstrukturen und ein dem optischen Bauteil zugeordnetes, seine momentane Lage anzeigendes Gebersystem,
h) je ein photoelektrisches Empfängersystem zu Umsetzung der jeweiligen aus der Abtastung der Objektstrukturbilder resultierenden Lichtflüsse in elektrische Meßsignale und
i) eine Auswertungselektronik zur Verarbeitung dieser Meßsignale in Verbindung mit den Signalen des Gebersystems zum Zwecke der Meßwerterfassung, Anzeige, Steuerung und/oder Regelung.

Vorteilhafte Weiterbildungen des erfindungsgemäßen Verfahrens und der Anordnung zu dessen Durchführung sind Gegenstand der Unteransprüche.

In der Zeichnung ist die Erfindung in einem Ausführungsbeispiel schematisch dargestellt und im nachfolgenden näher beschrieben. Es zeigen:
- Fig. 1: ein Aufbauschema der erfindungsgemäßen Anordnung,
- Fig. 2: einen Schnitt durch die Anordnung entlang der Linie II-II in Seitenansicht und
- Fig. 3: einen Schnitt durch die erfindungsgemäße Anordnung längs der Linie III-III.

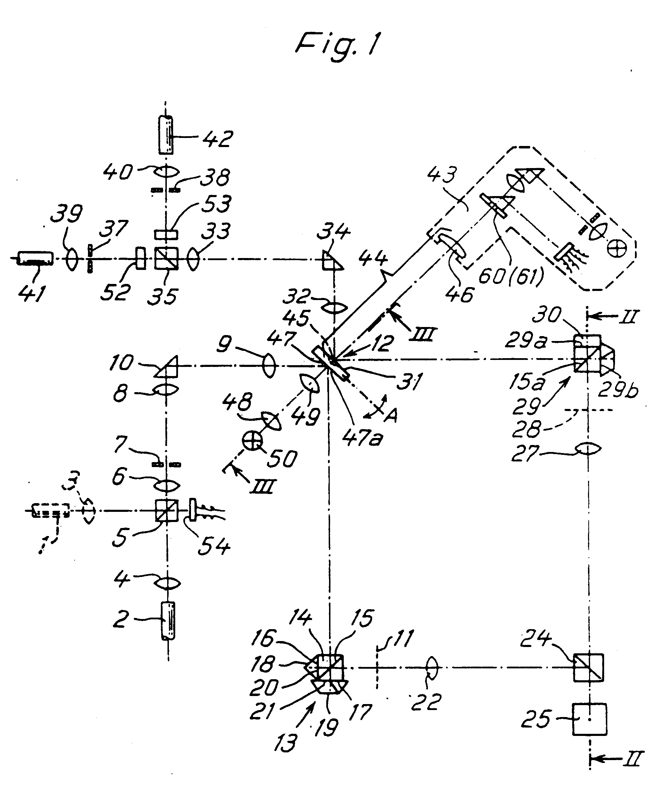

In Fig. 1 wird ein Beleuchtungsspalt durch die mit Lichtleiter 1, 2 zugeführte Beleuchtungsenergie einer nicht dargestellten Lichtquelle über Linsen 3, 4, ein Teilerprisma 5 sowie eine sammelnde Optik 6 beleuchtet. Die Länge des Spalts kann mittels einer Spaltlängenbegrenzungseinrichtung, die hier, da nicht zum Erfindungsgegenstand gehörend, nicht näher beschrieben ist, den zu untersuchenden Objektstrukturen angepaßt werden.

Eine aus Linsen 8, 9 und einem Umlenkprisma 10 bestehende erste Tubusoptik bildet den Beleuchtungsspalt 7 in eine den Lichtflüssen gemeinsame Zwischenbildebene 11 ab. Auf dem Wege dorthin werden die Lichtflüsse über einen in Richtung des Doppelpfeiles A schwenkbaren Schwingspiegel 12 geführt und durch ein polarisierendes Doppelbildprisma 13 geleitet.

Das Doppelbildprisma 13 setzt sich aus einem Teilerwürfel 14 mit einer als Polarisator wirkenden Teilerschicht 15 und an benachbarten Flächen 16, 17 befindlichen Dachkantprismen 18, 19 zusammen. Von letzteren ist das Dachkantprisma 19 45^{o} verdreht gegenüber dem Dachkantprisma 18 angeordnet. Außerdem ist zwischen die Flächen 16, 17 des Teilerwürfels 14 und die Dachkantprismen 18, 19 je ein Phasenplättchen 20 bzw. 21 eingefügt, so daß die Polarisationsrichtung des an den Dachkantprismen 18, 19 reflektierten Lichtes 90^{o} gedreht wird und der Lichtfluß in Richtung Zwischenbildebene 11 austreten kann und bei Verschwenken des Schwingspiegels 12 sich das eine Bild in der x-Koordinatenrichtung und das andere in der y-Koordinatenrichtung bewegt.

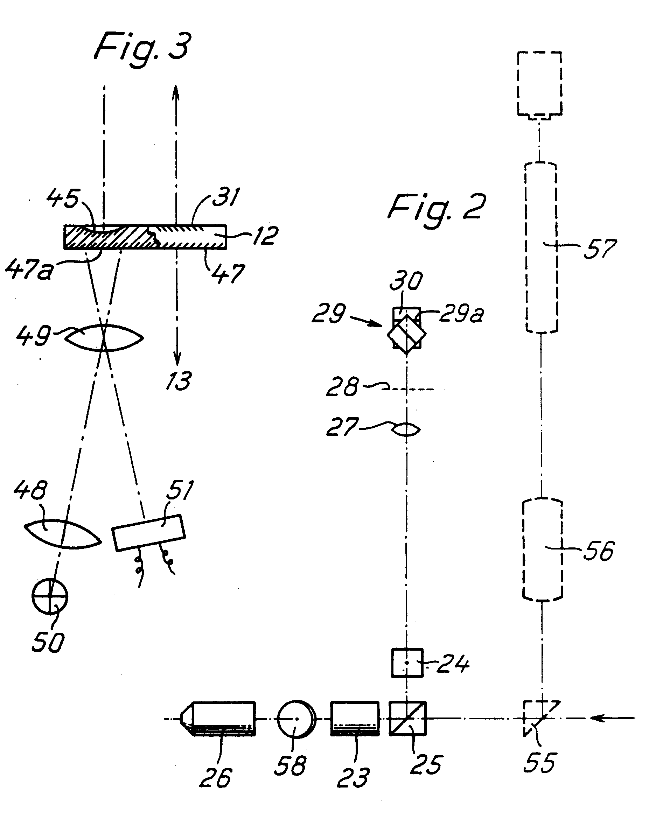

Nach Durchlaufen des Doppelbildprismas 13 werden beide Spaltbilder über Tubuslinsen 22 und 23 (Fig. 2), Teilerprisma 24 und Umlenkprisma 25 sowie ein abbildendes System 26 (Fig. 2) in die Objektebene projiziert, wo sie hier nicht mit dargestellte Objektstrukturen beleuchten.

Zur Ermittlung der Lage und Größe der spaltförmig beleuchteten Objektstrukturen werden diese durch das abbildende System 26 über die Tubuslinse 23, das Umlenkprisma 25, das Teilerprisma 24 sowie eine Feldlinse 27 zunächst in einer Zwischenbildebene 28 abgebildet. Von dort wird es von einem Doppelbildprisma 29 übernommen, dessen Aufbau dem des Doppelbildprisma 13 gleicht mit der Ausnahme, daß beim Doppelbildprisma 29 an die Stelle des Dachkantprisma 18 ein Planspiegel 30 tritt.

Im weiteren Verlauf gelangt der die Informationen über die Objektstrukturen tragende Lichtfluß zur Rückseite 31 des Schwingspiegels 12, die ihn umlenkt und einer aus Linsen 32, 33 mit zwischengeschaltetem Umlenkprisma 34 bestehenden zweiten Tubusoptik zuführt.

Die zweite Tubusoptik bildet die Zwischenbildebene 28 mit den beleuchteten Objektstrukturen nach Durchlaufen eines Teilerprismas 35 als Analysator auf die Spaltblenden 37, 38 ab. Die Teilerfläche des Prismas 35 führt dabei die durch die Doppelbildprismen 13, 29 polarisierten Lichtflüsse getrennt nach den Koordinatenrichtungen x und y den zugeordneten Spaltblenden 37, 38 zu.

In Verbindung mit Feldlinsen 39, 40 bildet die Tubusoptik 32-34 das in der Ebene der Spiegelrückseite 31 liegende Bild der Austrittspupille des abbildenden Systems 26 auf je ein hier nicht mit dargestelltes fotoelektrisches Empfängersystem oder zur Vermeidung von störenden Temperatureinflüssen auf die Meßeinrichtung auf je einen Lichtleiter 41 bzw. 42 ab. Diese sind dann je einem der hier nicht mitgezeigten fotoelektrischen Empfängersysteme zugeordnet, die außerhalb der Abtastanordnung montiert sind.

Zur Abtastung der Objektstrukturbilder wird der Schwingspiegel 12 verschwenkt. Damit wird bewirkt, daß die Bilder, nach Koordinatenrichtungen getrennt, über die Spaltblenden 37, 38 geführt werden. Die daraus resultierenden Lichtflüsse werden, wie oben beschrieben, den Lichtleitern 41 und 42 zugeführt, die sie an die außerhalb der Anordnung montierten fotoelektrischen Empfängersysteme weiterleiten. Diese nehmen in Abhängigkeit von der Spiegelstellung die Kantenfunktion auf und erzeugen daraus elektrische Signale, die zur Ermittlung der Objektstrukturmaße, zur Steuerung und/oder Regelung des verschiebbaren Tisches der Meßmaschine dienen.

Dadurch, daß der Schwingspiegel 12 bei seiner Schwenkbewegung den Beleuchtungsstrahlengang (mit seiner Vorderseite) und den Meßstrahlengang (mit der Rückseite) synchron auslenkt, ist gewährleistet, daß stets nur die von der Spaltblende 7 beleuchteten Objektstrukturen über die Spaltblenden 37, 38 geführt werden. Um eine inhomogene Ausleuchtung infolge von Beugung am Beleuchtungspalt 7 im Abtastbereich der Spaltblenden 37 und 38 zu vermeiden, kann der Beleuchtungsspalt 7 breiter als die Breite der Spaltblenden 37 und 38 ausgeführt sein.

Zur Erfassung der Bewegung des Schwingspiegels 12 ist ein an sich bekanntes Gebersystem 43 angeordnet. Dieses Gebersystem 43 beinhaltet ein nach dem Einspiegel-System aufgebautes Objektiv 44 aus Hohlspiegel 45 und Linse 46. Der Hohlspiegel 45 ist fest mit dem Schwingspiegel 12 verbunden. Zur Ermittlung der jeweiligen Schwingspiegelstellung wird ein Gitter 60 nach zweimaligem Durchlaufen des Objektivs 44 auf ein zweites Gitter 61 abgebildet. Die dabei entstehende Lichtmodulation wird zur Gewinnung von Zählimpulsen ausgenutzt, die aufsummiert ein Maß für die Spiegelauslenkung und damit auch ein Maß für die Auslenkung der Beleuchtungsspalt- und Objektstrukturbilder darstellen.

Da es sich aber beim Geber-System 43 um ein inkrementales Geber-System handelt, geht beim Abschalten der neuen Anordnung die genaue Lage des "Null"-Punktes für den Schwingspiegel 12 verloren. Die "Null"-Punktlage ist aber für die weiteren Berechnungen, insbesondere die Korrektur der Verzeichnung der innerhalb der Anordnung verwendeten optischen Systeme, wichtig. Es muß daher ein elektrischer Impuls erzeugt werden, welcher der "Null"-Punktlage entspricht. Dazu ist auf der Vorderseite des Schwingspiegels 12 eine gesonderte Spiegelfläche 47a vorgesehen, die über die Linse 48 und eine Kollimatorlinse 49 mit Licht aus einer Leuchtdiode 50 bestrahlt wird. Das reflektierte Licht fällt auf eine in der Ebene der Linse 48 angeordnete Differenzdiode 51, aus der dann ein "Null"-Impuls abgeleitet werden kann, wenn beide Diodenflächen gleich stark beleuchtet werden.

Für die genaue Justierung der Beleuchtungsspaltbilder zu den Abtastspalten ist jeweils vor jede Spaltblende 37, 38 eine schwenkbare Planparallelplatte 52 bzw. 53 gelegt, mit welchen eine Fein-Regelung möglich ist.

Schwankungen im aus den Lichtleitern 1 und 2 austretenden Licht werden von mindestens einem fotoelektrischen Empfängersystem 54 erfaßt, welches hinter den Teilerwürfel 5 gelegt ist und dessen Ausgangssignale bei Variation der Beleuchtungsstärke zur Korrektur der Kantenfunktionen verwendet werden können.

Wenn, auch wechselweise, nur in einer Koordinatenrichtung abgetastet werden soll, so ist der Teilerwürfel 5 polarisierend auszuführen und das Licht für die beiden Koordinatenrichtungen durch zwei, den Koordinatenrichtungen zugeordneten Lichtleitern 1, 2 zuzuführen.

Es ist außerdem vorgesehen, das vom abbildenden System 26 erzeugte Bild einer TV- oder einer CCD-Kamera zuzuführen. Dazu ist das Umlenkprisma 25 mit einer Teilerschicht ausgerüstet, welche sowohl die Objektstrukturbilder als auch die Bilder der Beleuchtungsspalte ausspiegelt und über ein rechtwinkliges Prisma 55 beispielsweise einer gestrichelt angedeuteten Vario-Optik 56, 57 einer solchen Kamera zuführt.

Wie in Fig. 2 gestrichelt angedeutet, kann auch zwischen abbildendem System 26 und der Tubuslinse 23 ein weiterer Teilerspiegel 58 vorgesehen sein, der zur Einspiegelung einer Auflichtbeleuchtung für die TV-Kamera und/oder einer Laser-Autofokuseinrichtung dient.

Der Vorteil der neuen Anordnung liegt darin, daß durch die Verwendung der Doppelbildprismen 13, 29 und des Teilerwürfels 5 mit polarisierenden Eigenschaften mit einem Ablenkelement 12 bei geringer Temperaturbelastung in beiden Koordinatenrichtungen gleichzeitig abgetastet werden kann.

Außerdem hat die bei der Abbildung eines schmalen Spaltes auf das Objekt auftretende Lichtbeugung keinen störenden Einfluß auf die Kantenabtastung.

Ein weiterer Vorteil der neuen Anordnung ist, daß sie sich ebenfalls wie die in der veröffentlichten europäischen Patentanmeldung EP-A-0 218 613 beschriebene Einrichtung zum Erfassen der Lage von Flächen eignet, da nach zweimaliger Spiegelung an der Planfläche des zu prüfenden Spiegels und der Reflexion in einem Hohlspiegel eine gegenläufige Bewegung zwischen Beleuchtungsspaltbild und Spaltebene auf die Objektebene bezogen ergibt, so daß von beiden Kanten des Beleuchtungsspaltbildes die Kantenfunktion aufgenommen und die genaue Lage der Spiegelfläche ermittelt werden kann.

Desweiteren kann die neue Einrichtung, wie in EP-A-0 218 613 beschrieben, auch zur Ermittlung der Ebenheit der im Gerät eingesetzten Spiegel in eingebautem Zustand verwendet werden.

## Patentansprüche

1. Verfahren zur Ausrichtung, Prüfung und/oder Vermessung zweidimensionaler, auf einem wenigstens in zwei senkrecht zueinander verlaufenden Koordinatenrichtungen verschiebbaren Tisch einer Meßmaschine befindlicher Objekte, **bestehend aus folgenden Schritten:**
a) Erzeugen eines Leuchtstreifens mit für jede Koordinatenrichtung unterscheidbaren, in einem gemeinsamen Strahlengang vereinigten Lichtflüssen, sowie Umlenken dieses Strahlenganges an einem in seiner Lage veränderbaren optischen Bauteil (12),
b) Erzeugen eines getrennten Leuchtstreifens je Koordinatenrichtung aus den unterscheidbaren Lichtflüssen und Abbilden dieser Leuchtstreifen in einer Zwischenbildebene (11),
c) Projizieren der Leuchtstreifen auf die Objektstrukturen des jeweils zu vermessenden Objekts,
d) Abbilden der durch die Leuchtstreifen beleuchteten Objektstrukturen in einer weiteren Zwischenbildebene (28),
e) Zusammenführen der den Bildern der Objektstrukturen zugeordneten Lichtflüsse in einem gemeinsamen Strahlengang und Umlenkung dieses Strahlenganges an dem in seiner Lage veränderbaren optischen Bauteil (12),
f) synchrones Verlagern sowohl der Bilder der Leuchtstreifen als auch der Bilder der Objektstrukturen in beiden Koordinatenrichtungen durch Veränderung der Lage des optischen Bauteils (12), wobei dessen momentane Lage durch ein zugeordnetes Gebersystem (43) erfaßt wird,
g) Abbilden der Bilder der Objektstrukturen getrennt nach den den Koordinatenrichtungen zugeordneten Lichtflüssen auf Abtastmittel (37, 38),
h) Umsetzen der jeweiligen aus der Abtastung der Objektstrukturbilder resultierenden Lichtflüsse in elektrische Meßsignale und
i) Auswertung dieser Meßsignale in Verbindung mit den Signalen des Gebersystems (43) zum Zwecke der Meßwerterfassung, Anzeige, Steuerung und/oder Regelung.

2. Verfahren nach Anspruch 1, dadurch gekennzeichnet, daß die Leuchtstreifen je Koordinatenrichtung unterschiedliche Kennungen erhalten.

3. Verfahren nach Anspruch 1, dadurch gekennzeichnet, daß die aus den Objektstrukturen hervorgehenden Lichtflüsse je Koordinatenrichtung unterschiedlich gekennzeichnet werden.

4. Vorrichtung zur Durchführung des Verfahrens nach Anspruch 1 mit einem wenigstens in zwei Koordinatenrichtungen verschiebbaren Tisch einer Meßmaschine und einem darauf befindlichen Objekt, enthaltend
a) eine strahlenbegrenzende Mittel (7) enthaltende Beleuchtungseinrichtung (1-4) zum Erzeugen eines Leuchtstreifens, in dem für jede Koordinatenrichtung unterscheidbare Lichtflüsse vereinigt sind,
b) eine erste Tubusoptik (8,9,10) zur Abbildung des Leuchtstreifens in eine Zwischenbildebene (11),
c) in den Abbildungsstrahlengang vor der Zwischenbildebene (11) eingefügte strahlenteilende und bilddrehende optische Mittel (13) zum Erzeugen eines entsprechend den unterscheidbaren Lichtflüssen getrennten Leuchtstreifens je Koordinatenrichtung,
d) ein der Zwischenbildebene (11) nachgeordnetes, ein Teilerprisma (24) und ein abbildendes System (26) enthaltendes optisches System (22-26) zur Projektion der Leuchtstreifen auf die Objektstrukturen des jeweils zu vermessenden Objekts und zur Abbildung der von den Objektstrukturen reflektierten Lichtflüsse in eine weitere Zwischenbildebene (28),
e) ein zweites strahlenteilendes und bilddrehendes optisches Glied (29) zur Zusammenführung der den Bildern der Objektstrukturen zugeordneten Lichtflüsse in einem gemeinsamen Strahlengang,
f) eine dem optischen Glied (29) nachgeordnete zweite Tubusoptik (32,33,34) mit einem Teilerprisma (35) zur Abbildung der Bilder der Objektstrukturen auf Abtastmittel (37,38) getrennt nach den den Koordinatenrichtungen zugeordneten Lichtflüssen,
g) ein der ersten Tubusoptik (8,9 10) nachgeordnetes und der zweiten Tubusoptik (32,33,34) vorgeschaltetes, in seiner Lage veränderbares optisches Bauteil (12) zur synchronen Verlagerung sowohl der Bilder der Leuchtstreifen als auch der Bilder der Objektstrukturen und ein dem optischen Bauteil (12) zugeordnetes, seine momentane Lage anzeigendes Gebersystem (43),
h) je ein photoelektrisches Empfängersystem zu Umsetzung der jeweiligen aus der Abtastung der Objektstrukturbilder resultierenden Lichtflüsse in elektrische Meßsignale und
i) eine Auswertungselektronik zur Verarbeitung dieser Meßsignale in Verbindung mit den Signalen des Gebersystems (43) zum Zwecke der Meßwerterfassung, Anzeige, Steuerung und/oder Regelung.

5. Anordnung nach Anspruch 4, dadurch gekennzeichnet, daß je Koordinatenrichtung ein Lichtleiter (1, 2) vorgesehen ist, deren Lichtflüsse in einem Prisma (5) zusammengeführt und mit je einer unterschiedlichen Kennung versehen werden.

6. Anordnung nach Anspruch 5, dadurch gekennzeichnet, daß zur unterschiedlichen Kennung der den Koordinatenrichtungen zugeordneten Lichtflüssen wenigstens ein Polarisator (15) vorgesehen ist.

7. Anordnung nach Anspruch 6, dadurch gekennzeichnet, daß zusätzlich optische Bauteile (20, 21) vorgesehen sind, welche den Polarisationszustand des vom Polarisator (15) erzeugten Lichtes ändern.

8. Anordnung nach Anspruch 4, dadurch gekennzeichnet, daß die Abtastmittel Spaltblenden (37, 38) enthalten.

9. Anordnung nach Anspruch 4 und 8, dadurch gekennzeichnet, daß optische Mittel (52, 53) zur Fein-Einregelung nach Länge und/oder Breite der Leuchtstreifen vorgesehen sind.

10. Anordnung nach den Ansprüchen 4 und 8, dadurch gekennzeichnet, daß im Strahlengang zwischen abbildendem System (26) und den Abtastmitteln (37, 38) wenigstens ein Polarisator (15a) angeordnet ist.

11. Anordnung nach den Ansprüchen 4, 8 und 10, dadurch gekennzeichnet, daß im Strahlengang zwischen abbildendem System (26) und Abtastmitteln (37, 38) zusätzlich zum Polarisator (15a) optische Mittel (29) vorgesehen sind, welche den Polarisationszustand des vom Polarisator (15a) erzeugten Lichtes ändern.

12. Anordnung nach Anspruch 4, dadurch gekennzeichnet, daß als strahlenteilendes optisches Glied zwischen abbildendem System (26) und Abtastmitteln (37, 38) ein Doppelbildprisma (29) vorgesehen ist.

13. Anordnung nach Anspruch 4, dadurch gekennzeichnet, daß die Rückseite (31) des die Leuchtstreifen verlagernden, in seiner Lage veränderbaren optischen Bauteils (12) zur Verlagerung des Bildes der Objektstrukturen in den beiden Koordinatenrichtungen verwendet ist.

14. Anordnung nach Anspruch 13, dadurch gekennzeichnet, daß Mittel (43, 44) zur Erfassung der jeweiligen Winkellage des in seiner Lage veränderbaren optischen Bauteils (12) vorhanden sind.

15. Anordnung nach Anspruch 14, dadurch gekennzeichnet, daß die Winkellage erfassenden Mittel ein an sich bekanntes, nach dem Einspiegel-System aufgebautes Objektiv (44) sowie ein an sich bekanntes Schrittgeber-System (43) enthalten.

16. Anordnung nach den Ansprüchen 4 bis 15, dadurch gekennzeichnet, daß dem in seiner Lage veränderbaren optischen Bauteil (12) ein Geber (47a, 48-50) zur Erzeugung eines Null-Impulses zugeordnet ist.

17. Anordnung nach Anspruch 16, dadurch gekennzeichnet, daß der Geber (47a, 48-50) ein Kollimatorsystem enthält.

18. Anordnung nach den Ansprüchen 4 bis 17, dadurch gekennzeichnet, daß den Lichtquellen der Beleuchtungseinrichtung (1, 2) fotoelektrische Mittel (54) nachgeschaltet sind, welche Schwankungen in der Beleuchtungshelligkeit erfassen und deren Ausgangssignale zur Einregelung der Beleuchtungshelligkeit und/oder zur Korrektur der aus den jeweiligen Meßsignalen ermittelten Meßwerte dienen.

## Claims

1. Method for the orienting, testing and/or measuring of two-dimensional objects disposed on a table, which is displaceable in at least two co-ordinate directions extending one perpendicularly to the other, of a measuring machine, the method consisting of the following steps:
a) producing a strip of light with light fluxes, which are distinguishable for each co-ordinate direction and united in a common ray path, as well as deflecting this ray path at an optical component (12), which is variable in its position,
b) producing a separate strip of light for each co-ordinate direction from these light fluxes and imaging these strips of light in an intermediate image plane (11),
c) projecting the strips of light onto the object structures of the object respectively to be measured,
d) imaging the object structures, which are illuminated by the strips of light, in a further intermediate image plane (28),
e) guiding the light fluxes, which are associated with the images of the object structures, together into a common ray path and deflecting this ray path at the optical component (12), which is variable in its position,
f) synchronous repositioning of the images of the strips of light as well as also of the images of the object structures in both co-ordinate directions by varying the position of the optical component, wherein the momentary position thereof is detected by an associated transmitter system,
g) imaging the images of the object structures separately according to the light fluxes, which are associated with the co-ordinate directions, onto scanning means (37, 38),
h) converting the respective light fluxes, which result from the scanning of the object structure images, into electrical measurement signals and
i) evaluating these measurement signals in conjunction with the signals of the transmitter system (43) for the purpose of the measurement value detection, indication, control and/or regulation.

2. Method according to claim 1, characterised thereby, that the strips of light receive different identifications for each co-ordinate direction.

3. Method according to claim 1, characterised thereby, that the light fluxes emanating from the object structures are characterised differently for each co-ordinate direction.

4. Device for the performance of the method according to claim 1 with a table, which is displaceable in at least two co-ordinate directions extending one perpendicularly to the other, of a measuring machine and an object disposed thereon, the device containing
a) an illuminating equipment, which contains ray-limiting means, for the production of a strip of light, in which light fluxes distinguishable for each co-ordinate direction are united,
b) a first optical tubus system for imaging the strip of light into an intermediate image plane,
c) beam-splitting and image-rotating optical means, which are inserted into the imaging ray path in front of the intermediate image plane, for the production of a strip of light, which is separated in correspondence with the distinguishable light fluxes, for each co-ordinate direction,
d) an optical system, which contains a splitter prism and an imaging system and is arranged behind the intermediate image plane, for the projection of the strips of light onto the object structures of the object respectively to be measured and for the imaging of the light fluxes reflected by the object structures into a further intermediate image plane,
e) a second beam-splitting and image-rotating optical member for guiding the light fluxes, which are associated with the images of the object structures, together into a common ray path,
f) a second optical tubus system which is arranged behind the optical member, with a splitter prism for imaging the images of the object structures separately according to the light fluxes, which are associated with the co-ordinate directions, onto scanning means,
g) an optical component, which is variable in its position and connected behind the first optical tubus system and in front of the second optical tubus system, for synchronous repositioning of the images of the strips of light as well as also of the images of the object structures and a transmitter system, which is associated with the optical component and indicates its momentary position,
h) a respective photo-electric receiver system for converting the respective light fluxes, which result from the scanning of the object structure images, into electrical measurement signals and
i) an electronic evaluating system for the processing of these measurement signals in conjunction with the signals of the transmitter system for the purpose of the measurement value detection, indication, control and/or regulation.

5. Arrangement according to claim 4, characterised thereby, that two optical conductors (1, 2), the light fluxes of which are guided together in a prism (5) and each provided with a respective different identification, are provided one for each co-ordinate direction.

6. Arrangement according to claim 5, characterised thereby, that at least one polariser (15) is provided for the different identification of the light fluxes associated with the co-ordinate directions.

7. Arrangement according to claim 6, characterised thereby, that optical components (20, 21), which vary the state of polarisation of the light produced by the polariser (15), are provided in addition.

8. Arrangement according to claim 4, characterised thereby, that the scanning means contain slit apertures (37, 38).

9. Arrangement according to claim 4 and characterised thereby, that optical means (52, 53) are provided for the fine regulation according to length and/or width of the strips of light.

10. Arrangement according to the claims 4 and 8, characterised thereby, that at least one polariser (15a) is arranged in the ray path between the imaging system (26) and the scanning means (37, 38).

11. Arrangement according to the claims 4, 8 and 10, characterised thereby, that optical means (29), which vary the state of polarisation of the light produced by the polariser (15a), are provided additionally to the polariser (15) in the ray path between the imaging system (26) and the scanning means (37, 38).

12. Arrangement according to claim 4, characterised thereby, that a double image prism (29) is provided as beam-splitting optical member between the imaging system (26) and the scanning means (37, 38).

13. Arrangement according to claim 4, characterised thereby, that the rear side (31) of the optical component (12), which is variable in its position and repositions the strips of light, is used for repositioning the image of the object structures in both the co-ordinate directions.

14. Arrangement according to claim 13, characterised thereby, that means (43, 44) are present for detecting the respective angular position of the optical component (12), which is variable in its position.

15. Arrangement according to claim 14, characterised thereby, that the means detecting the angular position contain an in itself known objective (44) built up on the principle of the imaging system as well as an in itself known step transmitter system (45).

16. Arrangement according to the claims 4 to 15, characterised thereby, that a transmitter (47a, 48 to 50) for the generation of a zero pulse is associated with the optical component (12), which is variable in its position.

17. Arrangement according to claim 16, characterised thereby, that the transmitter (47a, 48 to 50) contains a collimator system.

18. Arrangement according to the claims 4 to 17, characterised thereby, that photo-electric means (54), which detect fluctuations in the brightness of the illumination and the output signals of which serve for the regulation of the brightness of the illumination and/or for the correction of the measurement values ascertained from the respective measurement signals, are connected downstream of the light sources of the illuminating equipment (1, 2).

## Revendications

1. Procédé pour aligner, contrôler et/ou mesurer des objets bidimensionnels se trouvant sur une table déplaçable au moins suivant deux directions de coordonnées s'étendant perpendiculairement l'une à l'autre d'une machine à mesurer, comprenant les étapes consistant à:
a) produire une bande lumineuse avec des flux lumineux pouvant être distingués dans chaque direction de coordonnée, réunis en un trajet de rayons commun, ainsi qu'à faire dévier ce trajet de rayons à un composant optique (12) dont la position peut être modifiée,
b) produire une bande lumineuse séparée par direction de coordonnées à partir des flux lumineux pouvant être distingués et à reproduire ces bandes lumineuses dans un plan d'image intermédiaire (11),
c) projeter les bandes lumineuses sur les structures d'objet de l'objet à mesurer, respectivement,
d) représenter les structures d'objet éclairées par les bandes lumineuses dans un autre plan d'image intermédiaire (28),
e) réunir les flux lumineux associés aux images des structures d'objet en un trajet de rayons commun et faire dévier ce trajet de rayons à un composant optique (12) dont la position peut être modifiée,
f) déplacer de manière synchrone aussi bien les images des bandes lumineuses que les images des structures d'objet dans les deux directions de coordonnées en modifiant la position du composant optique (12), la position instantanée duquel étant saisie par un système capteur (43) associé,
g) représenter les images des structures d'objet séparément suivant les flux lumineux associés aux directions des coordonnées sur des moyens de balayage (37,38),
h) convertir les flux lumineux respectifs résultant du balayage des images de structures d'objet en des signaux de mesure électriques et
i) exploiter ces signaux de mesure en rapport avec les signaux du système capteur (43) dans le but de la saisie, l'indication ou l'affichage, la commande et/ou le réglage des valeurs de mesure.

2. Procédé selon la revendication 1 caractérisé en ce que les bandes lumineuses reçoivent des caractéristiques différentes selon la direction de coordonnée.

3. Procédé selon la revendication 1, caractérisé en ce que les flux lumineux résultant des structures d'objet sont caractérisés différemment selon la direction de coordonnée.

4. Dispositif pour la mise en oeuvre du procédé selon la revendication 1 avec une table déplaçable au moins suivant deux directions de coordonnées d'une machine à mesurer et un objet se trouvant sur celle-ci, comprenant:
a) un dispositif d'éclairage (1-4) contenant des moyens (7) limitants les rayons pour produire une bande lumineuse dans laquelle sont réunis des flux lumineux pouvant être distingués selon chaque direction de coordonnée,
b) un premier élément optique à tube (8,9,10) pour représenter la bande lumineuse dans un plan d'images intermédiaires (11),
c) des moyens optiques (13) divisant les rayons et faisant tourner l'image insérés dans le trajet de rayons de représentation avant le plan de l'image intermédiaire (11) pour produire une bande lumineuse séparée selon les flux lumineux qui peuvent être distingués par direction de coordonnée,
d) un système optique (22-26) disposé à la suite du plan de l'image intermédiaire (11), contenant un prisme séparateur (24) et un système représentant (26) pour la projection des bandes lumineuses sur les structures d'objet de l'objet respectif à mesurer et pour la représentation des flux lumineux réfléchis par les structures d'objet dans un autre plan d'image intermédiaire (28),
e) un deuxième organe optique divisant les rayons et faisant tourner l'image (29) pour réunir les flux lumineux associés aux images des structures d'objet dans un trajet de rayons commun,
f) un deuxième élément optique à tube (32,33,34) disposé à la suite de l'élément optique (29) avec un prisme séparateur (35) pour la représentation des images des structures d'objet sur des moyens de balayage (37,38) séparément suivant les flux lumineux associés aux directions des coordonnées,
g) un composant optique (12) dont la position peut être modifiée, placée à la suite du premier élément optique à tube (8, 9, 10) et inséré avant le deuxième élément optique à tube (32,33,34), pour le déplacement synchrone aussi bien des images des bandes lumineuses que des images des structures d'objet, et un système capteur (43) associé au composant optique (12) et indiquant la position instantanée de celui-ci,
h) un système récepteur photoélectrique pour convertir les flux lumineux respectifs résultant du balayage des images de structures d'objet en des signaux de mesure électriques et
i) un dispositif électronique d'exploitation ou d'analyse pour le traitement de ces signaux de mesure en rapport avec les signaux du système capteur (43) dans le but de la saisie, indication ou affichage, commande et/ou réglage des valeurs de mesure.

5. Dispositif selon la revendication 4, caractérisé en ce qu'il est prévu par direction de coordonnée un conducteur de lumière (1, 2) dont les flux de lumière sont réunis dans un prisme (5) et qui reçoivent, respectivement, des caractérisations différentes.

6. Dispositif selon la revendication 5, caractérisé en ce qu'il est prévu au moins un polariseur (15) pour caractériser différemment les flux lumineux associés aux directions des coordonnées.

7. Dispositif selon la revendication 6, caractérisé en ce que sont prévus en plus des composants optiques (20, 21) qui modifient l'état de polarisation de la lumière produite par le polariseur (15).

8. Dispositif selon la revendication 4, caractérisé en ce que les moyens de balayage comprennent des diaphragmes à fente (37,38).

9. Dispositif selon la revendication 4 et 8, caractérisé en ce que des moyens optiques (52,53) sont prévus pour le réglage fin suivant la longueur et/ou la largeur des bandes lumineuses.

10. Dispositif selon les revendications 4 et 8, caractérisé en ce qu'au moins un polariseur (15a) est disposé dans le trajet de rayons entre le système représentant (26) et les moyens de balayage (37,38).

11. Dispositif selon les revendications 4, 8 et 10, caractérisé en ce que des moyens optiques (29) sont prévus en plus du polariseur (15a) dans le trajet de rayons entre le système représentant (26) et les moyens de balayage (37,38) et qui modifient l'état de polarisation de la lumière produite par le polariseur (15a).

12. Dispositif selon la revendication 4, caractérisé en ce qu'il est prévu comme élément optique divisant les rayons entre le système représentant (26) et le moyens de balayage (37,38) un prisme à double image (29).

13. Dispositif selon la revendication 4, caractérisé en ce que le côté arrière (31) du composant optique (12) dont la position peut être modifiée, provoquant le déplacement des bandes lumineuses, est utilisé pour déplacer l'image des structures d'objet dans les deux directions de coordonnées.

14. Dispositif selon la revendication 13, caractérisé en ce que des moyens (43, 44) sont prévus pour saisir la position angulaire respective du composant optique (12) dont la position peut être modifiée.

15. Dispositif selon la revendication 14, caractérisé en ce que les moyens saisissant la position angulaire contiennent un objectif (44) connu réalisé selon le système à un miroir ainsi qu'un système de commande pas-à-pas (43) connu.

16. Dispositif selon les revendications 4 à 15, caractérisé en ce qu'il est associé au composant optique (12) dont la position peut être modifiée un générateur (47a, 48-50) pour produire une impulsion zéro.

17. Dispositif selon la revendication 16, caractérisé en ce que le générateur (47a, 48-50) comprend un système collimateur.

18. Dispositif selon les revendications 4 à 17, caractérisé en ce qu'on a inséré après les sources lumineuses du dispositif d'éclairage (1, 2) des moyens photoélectriques (54) qui captent des oscillations dans l'intensité lumineuse de l'éclairage et dont les signaux de sortie servent à régler l'intensité d'éclairage et/ou à corriger les valeurs de mesure obtenues à partir des signaux de mesure respectifs.
